# EUROPEAN PATENT APPLICATION

(11) **EP 4 694 586 A1**
(43) Date of publication of application: **11.02.2026**
(21) Application number: 23929009.1
(22) Date of filing: 25.04.2023
(51) Int. Cl.: H05K 3/20, B29C 59/02, G03F 7/20, H01L 21/027

(54) **METHOD FOR MANUFACTURING MASTER MOLD FOR IMPRINT**

(30) Priority: 24.03.2023 JP 2023047692
(71) Applicant: CONNECTEC JAPAN CORPORATION, Myoukou City Niigata 944-0020 (JP)
(72) Inventor: KOMATSU Hiroshi, Myoko-shi, Niigata 944-0020 (JP); SAKAI Daisuke, Myoko-shi, Niigata 944-0020 (JP)
(74) Representative: Hoffmann Eitle
(86) International application number: PCT/JP2023/016284
(87) International publication number: WO 2024/202075

(57) **Abstract**

Provided is a method for manufacturing a master mold for imprinting, with which structures formed in a desired forward taper can be formed on a base material. This method comprises a coating step in which a resist 3 having a predetermined film thickness is coated on a base material 1, an exposure step in which the resist 3 coated on the base material 1 is exposed through a mask 4, and a development step in which the exposed resist 3 is developed, the exposure step involving setting the exposure amount to be equal to or less than twice the minimum exposure amount (Df) at which the resist 3 coated on the base material 1 undergoes solarization across the entire thickness of the resist, and exposing predetermined portions of the resist 3, so that the side surface shape of the structures 2 constituted of the resist 3 formed by development in the development step is a forward taper.

## Description

### TECHNICAL FIELD

The present invention relates to a method for manufacturing a master mold for imprinting.

### BACKGROUND ART

The present applicant has proposed a technique disclosed in Patent Document 1 (hereinafter referred to as the "prior-art technique") regarding a method for forming wiring using imprinting.

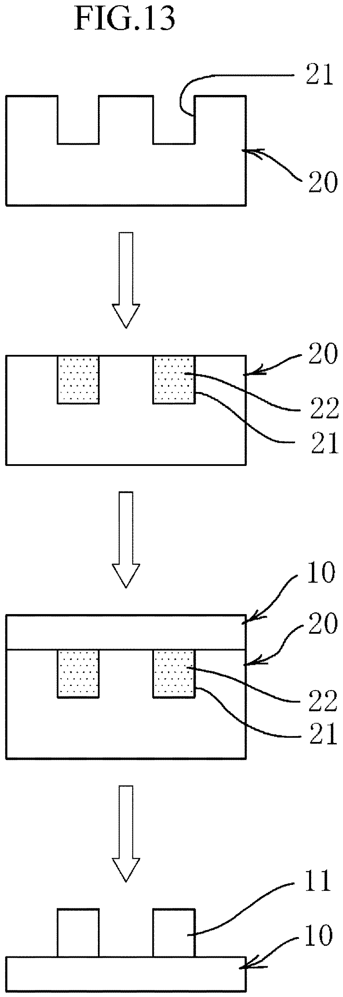

In this prior-art technique, as shown in FIG. 13, an electroconductive paste 22 is filled into recesses 21 formed in a replica mold 20, the recesses 21 having a pattern similar to a wiring pattern or bump pattern formed on a substrate 10, and the replica mold 20, with the electroconductive paste 22 filled in the recesses 21, is placed on the substrate 10 and pressurized (pressure welded). The electroconductive paste 22 in the recesses 21 of the replica mold 20 is thereby transferred to the substrate 10, and wiring 11 or bumps having a predetermined pattern are formed on the substrate 10.

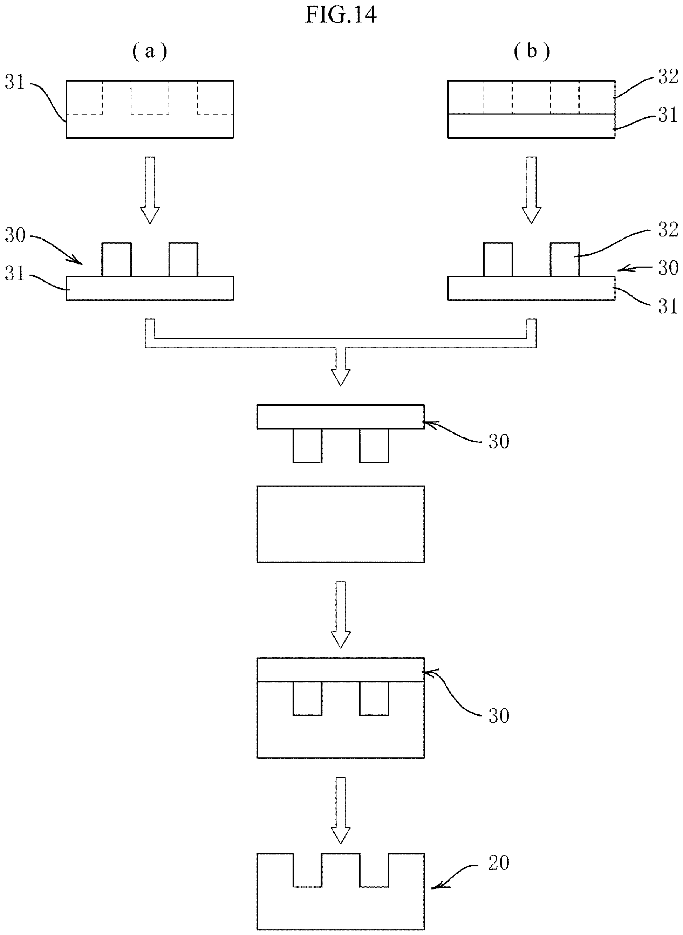

The replica mold 20 used in this prior-art technique is manufactured using a master mold 30 (an original) having structures (protrusions) exhibiting the wiring pattern or bump pattern on the substrate, as shown in FIG. 14. The structures of the master mold 30 are formed by etching a base material 31 (see FIG. 14(a)), or by patterning a resist 32 coated on the base material 31 (see FIG. 14(b)).

When the structures of the master mold are formed of a resist, in the prior art, the resist would be exposed to a sufficient amount of light, and the side shapes of the structures would thereby be nearly perpendicular to the base material.

However, if the side shapes of the structures are nearly perpendicular to the base material, the structures of the master mold may temporarily deform into an inverted taper during polymerization and pressurization to form the replica mold, and there is a risk of proper transfer not being possible.

Therefore, in order to manufacture the replica mold smoothly and at high yield, it is preferable that the side shapes of the master mold structures facing the base material have a forward taper. However, the shapes of the master mold structures are directly reflected in the shapes of the recesses in the replica mold, and the shapes of the recesses in the replica mold are directly reflected in the shapes of the wiring and bumps formed on the substrate; obstacles will inevitably arise in achieving smaller sizes and higher aspect ratios if, e.g., the taper angle becomes too large. Thus, it is not enough to simply form a taper; the master mold structures must be formed into a forward taper with a proper taper angle taking into consideration the size, pitch, aspect, etc., of the target pattern.

### [PRIOR ART DOCUMENTS]

### [PATENT DOCUMENTS]

Patent Document 1: Japanese Laid-open Patent Application No. 2021-111668

### SUMMARY OF THE INVENTION

### PROBLEMS THE INVENTION IS INTENDED TO SOLVE

However, no method has yet to be established for easily controlling the taper angle of the side shapes of structures in a master mold, and in order to make the side shapes of the master mold structures into a forward taper having the target taper angle, many complicated operations are required, which is labor-intensive and costly.

The present invention was devised in consideration of the current state as described above, it being an object of the invention to provide a method for manufacturing a master mold for imprinting, with which a structure formed in a forward taper at an optimal taper angle, taking into consideration the size, pitch, aspect, etc., of the target pattern, can easily be formed on a base material.

### MEANS FOR SOLVING SAID PROBLEMS

A summary of the present invention shall be described with reference to the accompanying drawings.

The present invention relates to a method for manufacturing a master mold for imprinting, the master mold having structures 2 formed on a base material 1 in a predetermined pattern such as a wiring pattern or a bump pattern, the method for manufacturing a master mold for imprinting characterized by comprising a coating step in which a resist 3 having a predetermined film thickness is coated on the base material 1, an exposure step in which the resist 3 coated on the base material 1 is exposed through a mask 4, and a development step in which the exposed resist 3 is developed, the exposure step involving setting the exposure amount to be equal to or less than twice Df (described below) and exposing predetermined portions of the resist 3 so that the side surface shape of the structures 2 constituted of the resist 3 formed by development in the development step is a forward taper.
Df: the minimum exposure amount at which the resist 3 coated on the base material 1 undergoes solarization across the entire thickness of the resist 3

The present invention also relates to the method for manufacturing a master mold for imprinting according to claim 1, characterized in that in the exposure step, a binary mask constituted of light-transmitting parts 4a and light-shielding parts 4b is used as the mask 4, and the exposure amount is set to D0 (below) to Df (above).
D0: the exposure amount at which the resist 3 coated on the base material 1 begins to undergo solarization

The present invention also relates to the method for manufacturing a master mold for imprinting according to claim 1, characterized in that in the exposure step, a grayscale mask constituted of light-transmitting parts 4a, light-shielding parts 4b, and grayscale parts 4c is used.

The present invention also relates to the method for manufacturing a master mold for imprinting according to claim 3, characterized in that the grayscale parts 4c are provided along opening edges of the light-transmitting parts 4a.

The present invention also relates to the method for manufacturing a master mold for imprinting according to any one of claims 1 to 4, characterized in that the exposure amount is determined on the basis of data on the relationship between the exposure amount for a predetermined thickness of the resist 3, which is ascertained in advance, and the taper angle of the forward taper.

The present invention also relates to the method for manufacturing a master mold for imprinting according to any one of claims 1 to 4, characterized in that a light-transmitting material is used as the base material 1, a negative resist 3 is used as the resist 3, the method includes a mask formation step in which the mask 4 is formed on the front surface of the base material 1, and the exposure step involves irradiating the base material 1 with light from the back-surface side thereof and exposing the resist 3 through the mask 4 formed on the front surface of the base material 1.

The present invention also relates to the method for manufacturing a master mold for imprinting according to claim 5, characterized in that a light-transmitting material is used as the base material 1, a negative resist 3 is used as the resist 3, the method includes a mask formation step in which the mask 4 is formed on the front surface of the base material 1, and the exposure step involves irradiating the base material 1 with light from the back-surface side thereof and exposing the resist 3 through the mask 4 formed on the front surface of the base material 1.

### EFFECT OF THE INVENTION

As described above, the present invention provides a method for manufacturing a master mold for imprinting with which it is possible to easily form, on a base material, structures constituted of a resist formed in a forward taper with an optimal taper angle taking into consideration the target pattern size, pitch, aspect, etc.

### BRIEF DESCRIPTION OF THE DRAWINGS

FIG. 1 is a schematic explanatory diagram of an example of the formation of structures in the present invention;
FIG. 2 is an explanatory diagram illustrating the solarization characteristics of a resist in example 1;
FIG. 3 is an explanatory diagram of the flow of steps in example 1;
FIG. 4 is a graph of the solarization characteristics of the resist (SU-8) in example 1;
FIG. 5 is SEM images of structures exposed at a predetermined film thickness with different exposure amounts when the negative resist of example 1 is used;
FIG. 6 is SEM images of structures exposed at a predetermined film thickness with different exposure amounts when the positive resist of example 1 is used;
FIG. 7 is an explanatory diagram of the flow of steps in example 2;
FIG. 8 is a schematic explanatory diagram of a mask (grayscale mask) when a negative resist is used in example 2;
FIG. 9 is an explanatory diagram (an explanation of a principle) of light intensity distribution during exposure when a grayscale mask is used in example 2;
FIG. 10 is an explanatory diagram (actual distribution) of a light intensity distribution during exposure when a grayscale mask is used in example 2;
FIG. 11 is an explanatory diagram (actual distribution) of a light intensity distribution during exposure when a binary mask is used in example 2;
FIG. 12 is a schematic explanatory diagram of a mask (grayscale mask) when a positive resist is used in example 2;
FIG. 13 is a cross-sectional schematic diagram of a wiring formation method using a replica mold in a prior-art example; and
FIG. 14 is a cross-sectional schematic diagram of a method for manufacturing a master mold and a method for manufacturing a replica mold using the master mold in a prior-art example.

### BEST MODE FOR CARRYING OUT THE INVENTION

Preferred embodiments of the present invention are briefly described below with reference to the drawings while indicating the effects of the present invention.

A resist 3 is coated on a base material 1, the resist 3 coated on the base material 1 is exposed to light through a mask 4, and the exposed resist 3 is developed to form structures 2 constituted of the resist 3.

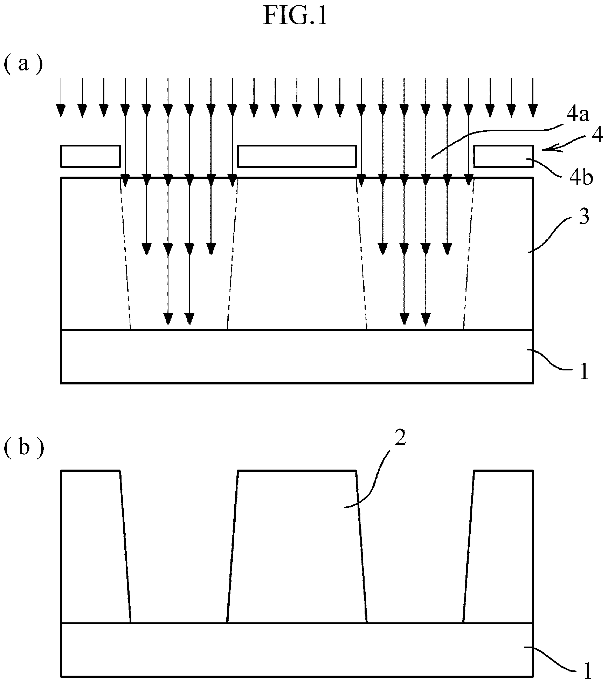

In the present invention, the exposure amount when exposing the resist 3 in the operation described above is set to be equal to or less than twice Df (the minimum exposure amount at which the resist 3 coated on the base material 1 undergoes solarization across the entire thickness of the resist). Therefore, as shown in FIG. 1(a), the resist 3 near the edges (ends) of light-transmitting parts 4a (openings) in the mask 4 is exposed under conditions in which the amount of light attenuates (exposure amount smaller than Df) in the film thickness direction of the resist 3, thereby making it possible to easily form structures 2 in which the side surface shapes are a forward taper relative to the base material 1 as shown in FIG. 1(b).

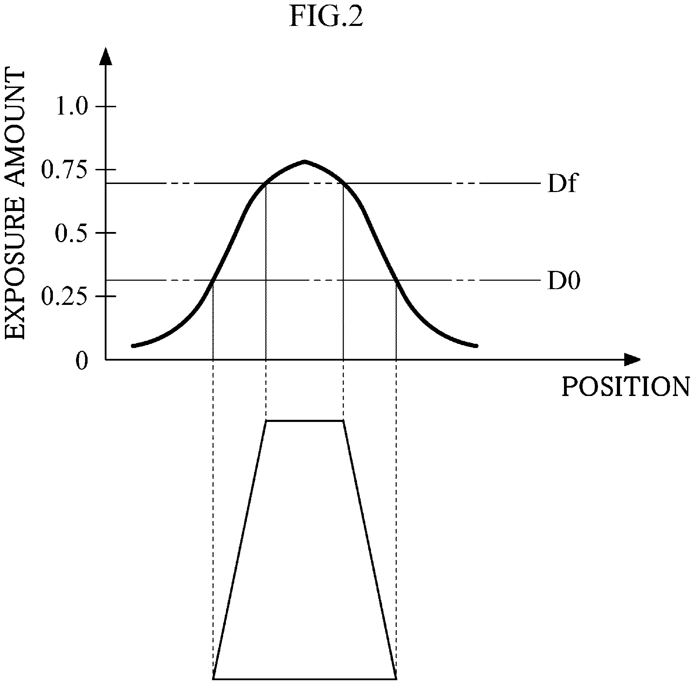

That is, for example, when the resist 3 is exposed through the mask 4, the amount of light near the edges of the light-transmitting parts 4a of the mask 4 is less than in the central parts due to diffraction of the light, resulting in a phenomenon in which the solarization effect decreases in the film thickness direction of the resist 3 near the edges of the light-transmitting parts 4a of the mask 4. Therefore, the exposure amount is set to be equal to or less than twice the minimum exposure amount (Df) at which the resist 3 coated on the base material 1 undergoes solarization across the entire thickness of the resist 3, whereby, as shown in FIG. 2, near the edges of the light-transmitting parts 4a of the mask 4, the amount of exposure decreases toward the edges, the solarization effect of the resist 3 in the film thickness direction decreases accordingly toward the edges, and it is thereby possible to obtain structures 2 having a forward taper.

Furthermore, for example, by using a grayscale mask having grayscale parts 4c on the edges of the light-transmitting parts 4a of the mask 4, in addition to the above-mentioned light diffraction, the exposure amount can be spatially changed by the action of the grayscale parts 4c, making it possible to obtain structures 2 having forward tapers with a larger taper angle.

### [Example 1]

A specific example 1 of the present invention shall be described with reference to FIGS. 1 to 6.

The present example is a method for manufacturing a master mold for imprinting on a base material 1, the master mold having structures 2 formed in a predetermined pattern such as a wiring pattern or a bump pattern.

Specifically, said method comprises a mask formation step in which a mask 4 is formed on a base material 1, a coating step in which a resist 3 is coated on the mask 4, an exposure step in which the resist 3 coated on the mask 4 is exposed through the mask 4, and a development step in which the exposed resist 3 is developed.

Specifically, in the exposure step of the present example, a photomask is not used, the resist 3 is formed in a predetermined pattern through the mask 4 formed on the base material 1, and structures 2 constituted of the resist 3 are formed.

The present example is a case in which a thick-film negative resist 3 is used as the resist 3. When this negative resist 3 is used, if light is directed from the front surface side of the resist 3 during exposure, the structures 2 will have an inverse taper with respect to the base material 1, so light is irradiated from the base material 1 side. Therefore, the base material 1 used is one that is light-transmitting.

Specifically, in the present example, SU-8 manufactured by Nippon Kayaku Co., Ltd. is used as the resist 3, and the base material 1 used is one that is made of glass.

Hereinafter, each step in the method for manufacturing a master mold for imprinting of the present example using the above-described base material 1 and resist 3 shall be described in detail.

First, in the mask formation step, a mask 4 having a predetermined pattern is formed on a glass base material 1.

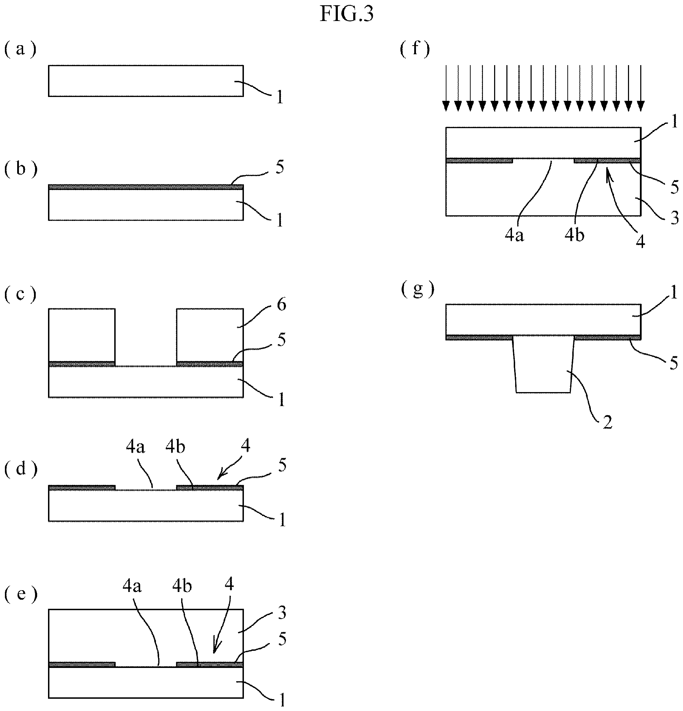

Specifically, a mask film 5 for forming the mask 4 is formed on the base material 1, and the mask film 5 is etched to a predetermined pattern. In the present example, Cr is sputtered as the mask film 5 onto the base material 1 (see FIG. 3(b)), a resist (a positive resist OFPR manufactured by Tokyo Ohka Kogyo Co., Ltd. is used in the present example) is coated on the Cr film 5, and the resist is exposed through a predetermined photomask and developed. The Cr film 5 is then etched through the resist (see FIG. 3(c)), and after the etching process, the resist is removed to form a binary mask constituted of light-transmitting parts 4a (openings) and light-shielding parts 4b (see FIG. 3(d)).

The mask film 5 may be of any thickness that can exhibit light blocking properties during exposure in the exposure step (in the present example, the thickness is set to 60 to 120 nm (changed as appropriate depending on exposure conditions)).

Furthermore, the mask film 5 is not limited to being obtained using Cr; any other material capable of exhibiting the same effects as those of the present example can be used as appropriate.

Next, in the coating step, a resist 3 for forming the structures 2 on the base material 1, in other words, a resist 3 that will become the structures 2, is coated on the base material 1.

Specifically, a resist 3 (SU-8) of a predetermined thickness is coated on the mask 4 formed on the base material 1 (see FIG. 3(e)).

The resist 3 for forming the structures 2 is not limited to the resist described above.

Next, in the exposure step, the resist 3 is exposed to light.

Specifically, light is directed from the rear side of the glass base material 1, and the resist 3 is exposed through the mask 4 provided between the glass base material 1 and the resist 3 (see FIG. 3(f)).

The exposure amount is set to be equal to or less than twice Df (described below), preferably D0 (described below) to Df, so that the side surface shape of the structures 2 formed by development has a forward taper relative to the base material 1.
D0: the exposure amount at which the resist 3 coated on the base material 1 begins to undergo solarization
Df: the minimum exposure amount at which the resist 3 coated on the base material 1 undergoes solarization across the entire thickness of the resist 3

More specifically, the exposure amount is set to the above range, which corresponds to the target taper angle, on the basis of data on the relationship between the exposure amount for a predetermined thickness of the resist 3, which was previously ascertained, and the taper angle of the forward taper.

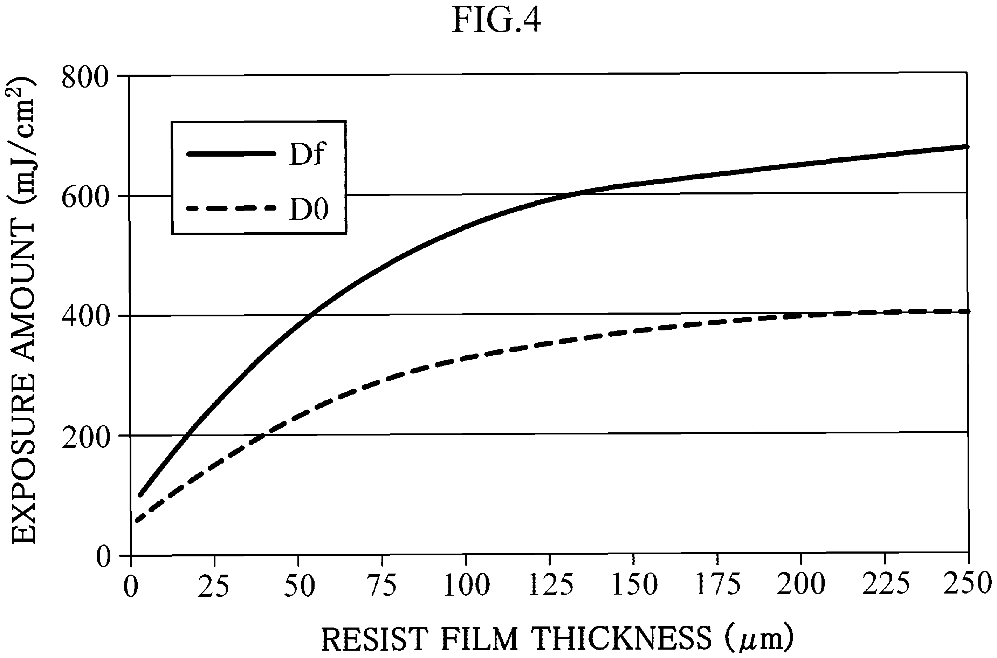

D0 and Df can be ascertained from, e.g., a data sheet disclosed by a manufacturer. In present example, D0 and Df are ascertained from the data sheet for SU-8 from Kayaku Advanced Materials, Inc. (https://kayakuam.com/wp-content/uploads/2020/09/KAM-SU-8-2-25-Datasheet-9.3.20-final.pdf), shown in FIG. 4.

In the present example, on the basis of the ascertained D0 and Df, data on the relationship between the exposure amount at a predetermined film thickness of the resist 3 and the taper angle of the forward taper is acquired by experimentation, and on the basis of this relationship data, the exposure amount corresponding to the target taper angle is set.

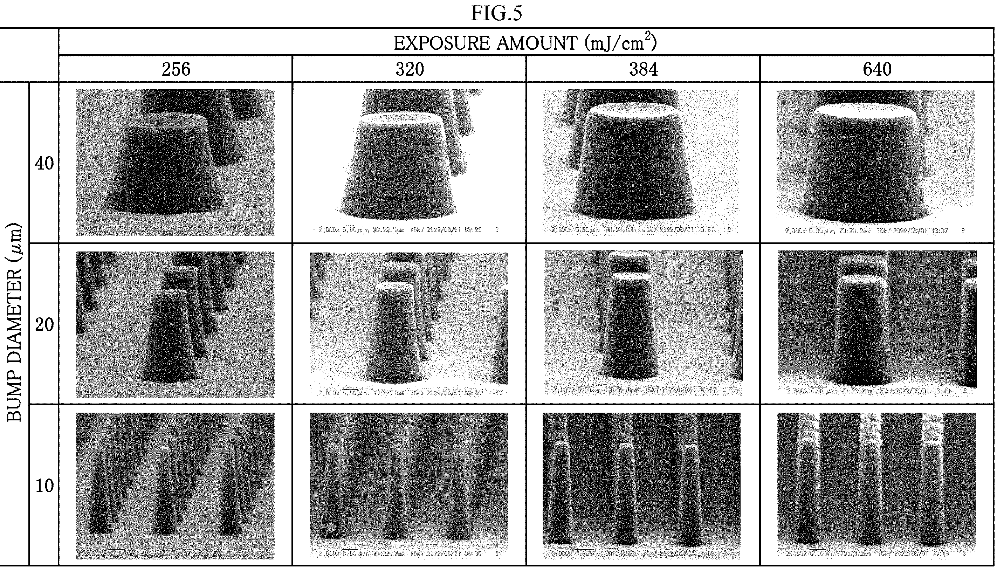

Specifically, in the present example, a TEG pattern having a bump pattern with different diameters or a wiring pattern with different line widths is used, and samples exposed at different exposure amounts are manufactured at a predetermined film thickness as shown in FIG. 5. The taper angle is determined from a SEM image, etc., of the bump pattern or wiring pattern (FIG. 5 shows a bump pattern) in the samples, and data on the relationship between the exposure amount at a predetermined film thickness and the taper angle of the forward taper is acquired.

For example, from FIG. 5, data on the relationship between the exposure amount and the taper angle, as shown in Table 1 below, can be acquired, and the exposure amount can be set on the basis of this data (taper angle), or a calculation formula for determining the exposure amount can be created and the exposure amount can be set using this calculation formula.

**[Table 1]**

| | | Exposure amount (mJ/cm²) | | | |
|---|---|---|---|---|---|
| | | 256 | 320 | 384 | 640 |
| Bump diameter (*µ*m) | 40 | 17.1° | 15.6° | 8.8° | 5.1° |
| | 20 | 7.3° | 5.9° | 5.4° | 3.4° |
| | 10 | 4.7° | 4.0° | 3.3° | 1.9° |

Finally, in the development step, the exposed resist 3 is developed.

Since a negative resist 3 is used in the present example, the resist 3 in the exposed portions remains, and structures 2 having side surfaces formed in the desired taper (taper angle) are formed by this remaining resist 3, completing the master mold (see FIG. 3(g)).

As described above, the present example is a case in which a negative resist 3 is used, but a positive resist 3 may also be used as the resist 3.

If a positive resist 3 is used, the mask formation step is unnecessary and a photomask is used in the exposure step.

In addition, unlike a negative resist 3, a positive resist 3 has no exposed portions. Therefore, in the exposure step, the front-surface side of the resist 3 is exposed, and the remaining resist 3 becomes the structures 2, as shown in FIG. 1.

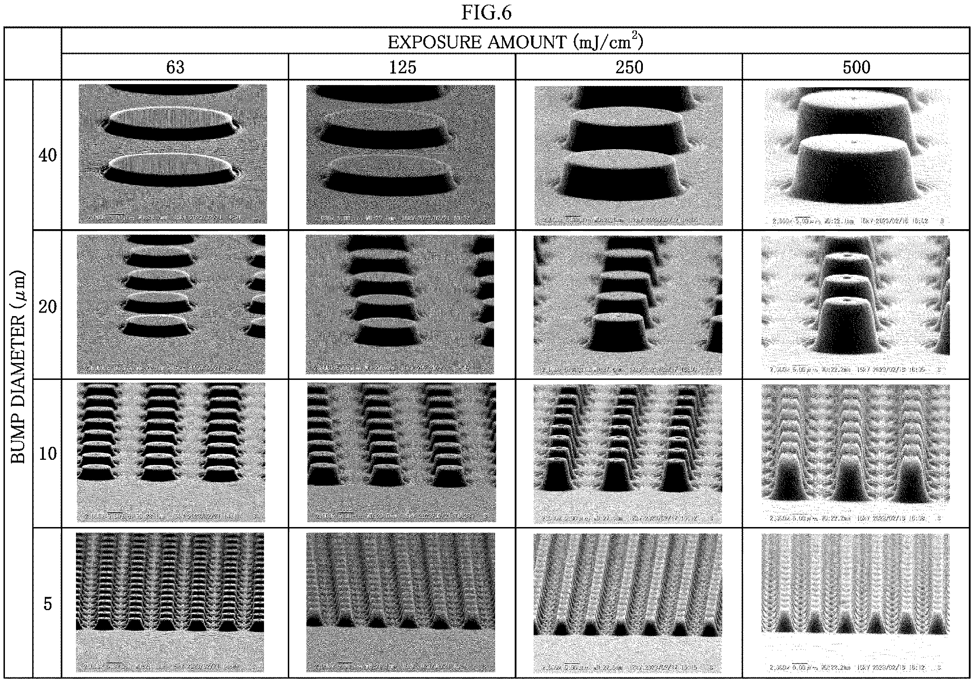

FIG. 6 shows the shapes of the structures 2 in samples exposed using different exposure amounts at a predetermined film thickness, using PMER P-LA900 manufactured by Tokyo Ohka Kogyo Co., Ltd. as the resist 3 and using the same TEG pattern as in the case of the negative resist 3.

As shown in FIG. 6, in the case of a positive resist 3, it can be confirmed that the taper angle of the structures 2 changes by changing the exposure amount, as with the negative resist 3. The taper angle can be determined from SEM images, etc., of the bump patterns or wiring patterns of these samples, and data on the relationship between the exposure amount at a predetermined film thickness and the taper angle of the forward taper can be acquired.

As described above, the present example provides a method for manufacturing a master mold for imprinting with which it is possible to easily form, on a base material 1, structures 2 formed in a forward taper having an optimal taper angle taking into consideration the size, pitch, aspect, etc., of the target pattern.

That is, in the present example, since the exposure amount of the resist 3 forming the structures 2 is set to D0 (the exposure amount at which the resist 3 coated on the base material 1 begins to undergo solarization) to Df (the minimum exposure amount at which the resist 3 coated on the base material 1 undergoes solarization across the entire thickness of the resist 3), near the edges of the light-transmitting parts 4a of the mask 4, the exposure amount decreases toward the edges, the solarization effect in the film thickness direction of the resist 3 accordingly decreases toward the edges, and it is thereby possible to reliably form structures 2 in which the side surface shape is a forward taper.

Consequently, even if the structures of the master mold deform during polymerization and pressurization when the replica mold is formed, a reverse taper is prevented, and it is possible to manufacture a master mold in which the pattern is transferred smoothly and at a high yield.

### [Example 2]

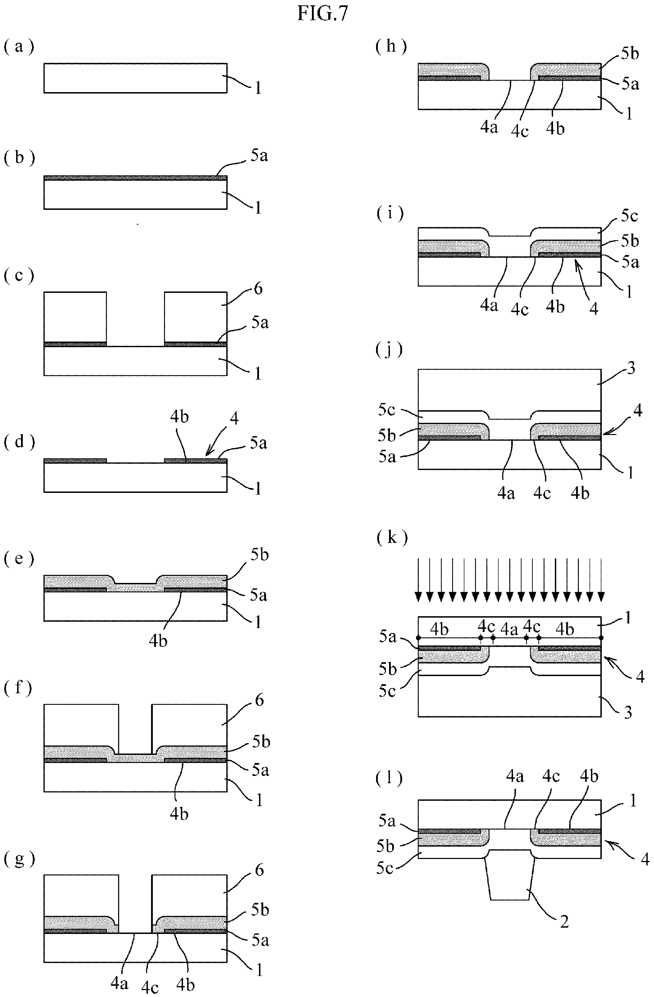

A specific example 2 of the present invention shall be described with reference to FIGS. 7 to 12.

The present example is a case in which a mask 4 different from that of example 1 is used.

Specifically, in the present example, a grayscale mask is used as the mask 4, and the grayscale mask is constituted of light-transmitting parts 4a, light-shielding parts 4b, and grayscale parts 4c.

The present example is described in detail below, but the flow of steps of the present example is the same as in example 1 other than the mask formation step; therefore, steps other than the mask formation step shall not be described.

When a grayscale mask is used for the mask 4 as in the present example, there are no limitations as to the exposure amount, but the exposure conditions are preferably those of the exposure step in example 1, i.e., the exposure amount is preferably equal to or less than twice Df.

In the mask formation step of the present example, first, a light-shielding part film 5a for forming the light-shielding parts 4b of the mask 4 is formed on the base material 1, and the light-shielding part film 5a is etched to form a predetermined pattern. For the light-shielding part film 5a in the present example, a Cr film is formed on the base material 1 (see FIG. 7(b)) by sputtering as in example 1, a resist 6 (a positive resist OFPR made by Tokyo Ohka Kogyo Co., Ltd. is used in the present example) is coated on the Cr film 5a, and the resist 6 is exposed through a predetermined photomask and developed, after which the Cr film 5a is etched through the resist 6 (see FIG. 7(c)), and the resist 6 is removed after the etching process to form light-shielding parts 4b composed of the Cr film 5a on the base material 1 (see FIG. 7(d)).

Next, a grayscale part film 5b for forming the grayscale parts 4c of the mask 4 is formed on the base material 1 including the light-shielding parts 4b, and the grayscale part film 5b is etched to form a predetermined pattern. In the present example, a CrO₃ film is formed by sputtering as the grayscale part film 5b on the base material 1 including the light-shielding parts 4b (see FIG. 7(e)), a resist 6 (a positive resist OFPR made by Tokyo Ohka Kogyo Co., Ltd. is used in the present example) is coated on the CrO₃ film 5b, and the resist 6 is exposed through a predetermined photomask and developed (see FIG. 7(f)), after which the CrO₃ film 5b is etched through the resist 6 (see FIG. 7(g)), and the resist 6 is removed after the etching process to form light-transmitting parts 4a and grayscale parts 4c on the base material 1 (see FIG. 7(h)) and to form a grayscale mask constituted of light-transmitting parts 4a, light-shielding parts 4b, and grayscale parts 4c on the base material 1.

In the present example, in order to improve the adhesion of the resist 3, an adhesive film 5c (SiO₂ film) is formed on the mask 4 formed as described above (see FIG. 7(i)).

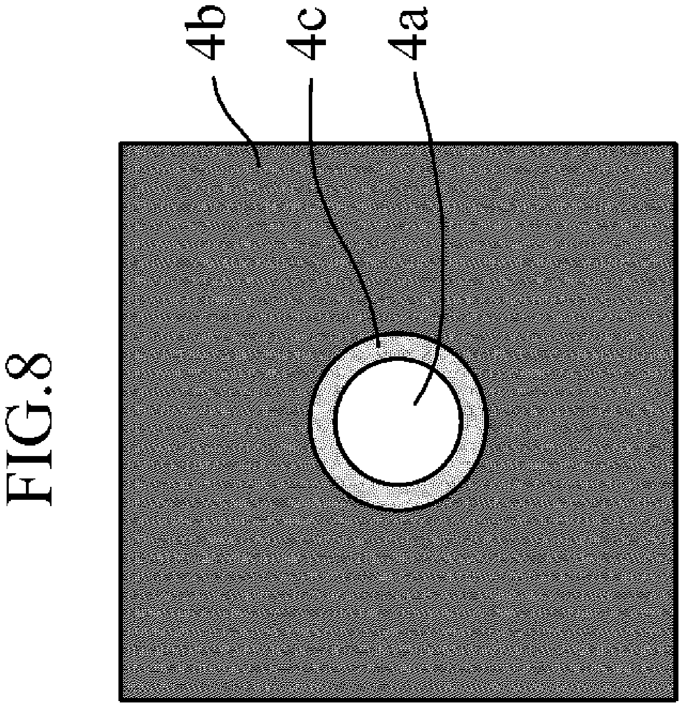

FIG. 8 shows an example of the configuration of the mask 4 (gray scale mask) for the bump pattern formed as described above. As shown in FIG. 8, in the mask 4 of the present example, the grayscale parts 4c are provided at the boundaries between the light-transmitting parts 4a and the light-shielding parts 4b, along the peripheral edges of the light-transmitting parts 4a. The exposure amount decreases due to light passing through the grayscale parts 4c, the solarization effect in the film thickness direction of the resist 3 decreases accordingly, and due to an interaction with the light diffraction effect, it is possible to easily form structures 2 having a forward taper with a greater taper angle than when a binary mask is used (see FIGS. 7(k) and 7(j)).

The exposure mechanism in the case of using a grayscale mask shall be described below.

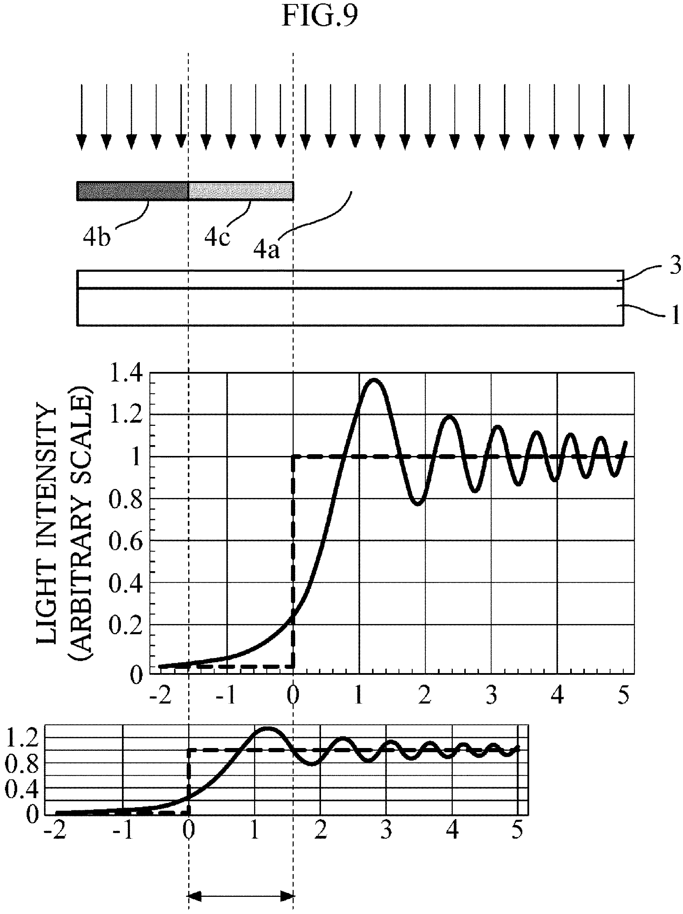

FIG. 9, relating to a grayscale mask such as that of the present example, shows an intensity distribution derived on the basis of the Fresnel diffraction of light passing through the light-transmitting parts 4a (the upper graph), and an intensity distribution derived on the basis of the Fresnel diffraction of light passing through the grayscale parts 4c (the lower graph).

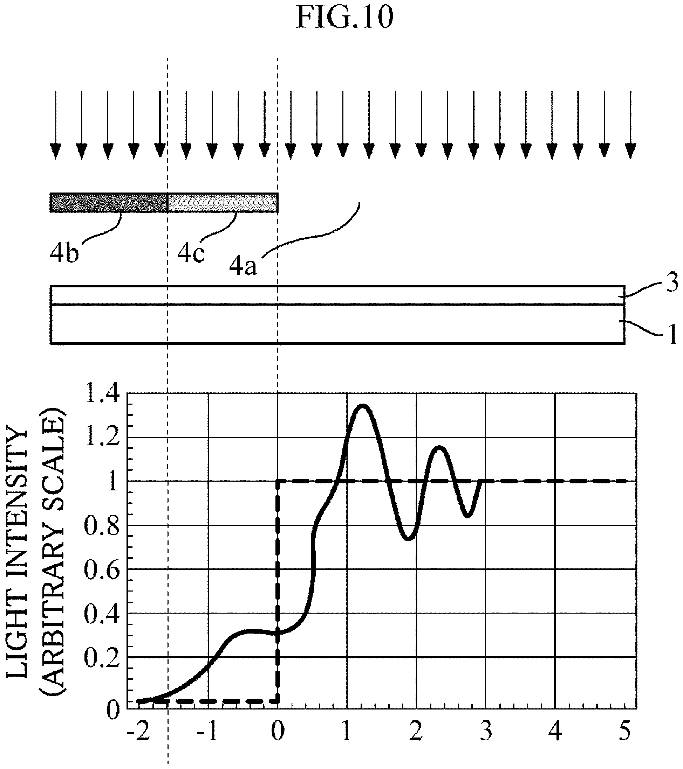

In a configuration of grayscale parts 4c such as is shown in FIG. 9, since the grayscale parts 4c are within a range at which Fresnel diffraction occurs, an intensity distribution derived on the basis of the Fresnel diffraction of light passing through the light-transmitting parts 4a and an intensity distribution derived on the basis of the Fresnel diffraction of light passing through the grayscale parts 4c can be superimposed (combined). Therefore, the grayscale mask of the present example has a light intensity distribution such as is shown in FIG. 10.

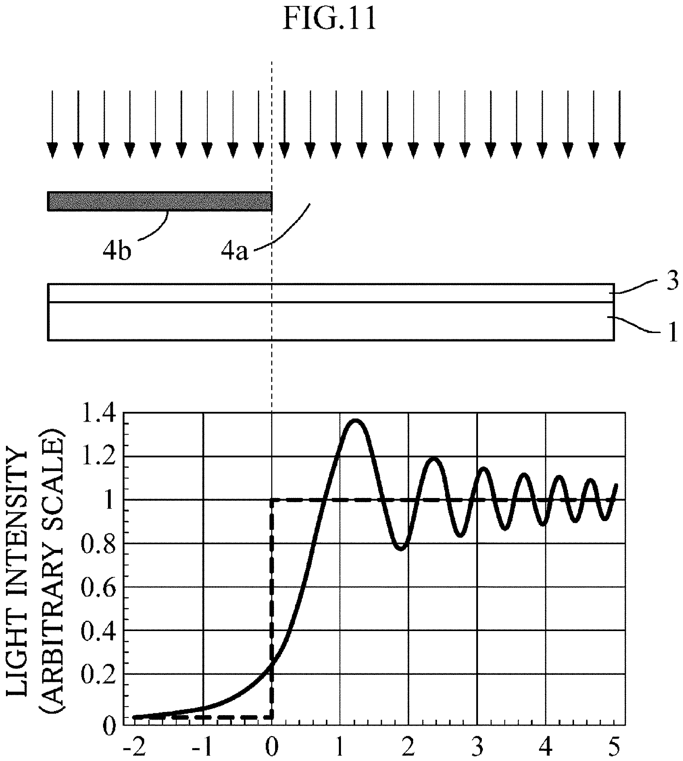

The light intensity distribution when the grayscale mask shown in FIG. 10 is used is equivalent to a light intensity distribution that is shifted toward that of the light-shielding parts 4b (to the left in the diagram), by an amount proportionate to the area (width) of the grayscale parts 4c, from the light intensity distribution in the case of the binary mask shown in FIG. 11. Therefore, due to the use of the grayscale mask, the amount by which the side surfaces of the structures 2 recede increases by an amount proportionate to the grayscale parts 4c, and the taper angle of the side surfaces of the structures 2 increases accordingly.

Table 2 below shows the results of measuring the side surface taper angle in structures 2 having a bump diameter of 10 µm when a resist 3 having a film thickness of 40 µm is exposed using a binary mask and when said resist is exposed using a grayscale mask. In the grayscale mask that was used, the area (width) of the grayscale parts 4c was 1.5 µm.

**[Table 2]**

| | Binary mask | | Grayscale mask | |
|---|---|---|---|---|
| Exposure amount (mJ/cm²) | 256 | 640 | 256 | 640 |
| Taper angle (° ) | 4.7 | 1.9 | 6.4 | 4.5 |

From the results shown in table 2, it can be confirmed that using a grayscale mask makes it possible to increase the taper angle of the side surfaces of the structures 2.

As described above, the present example is a case of using a negative resist 3, but a positive resist 3 (e.g., PMER P-LA900 made by Tokyo Ohka Kogyo Co., Ltd., or the like) may also be used as the resist 3.

When a positive resist 3 is used, the mask formation step is unnecessary and a photomask is used in the exposure step.

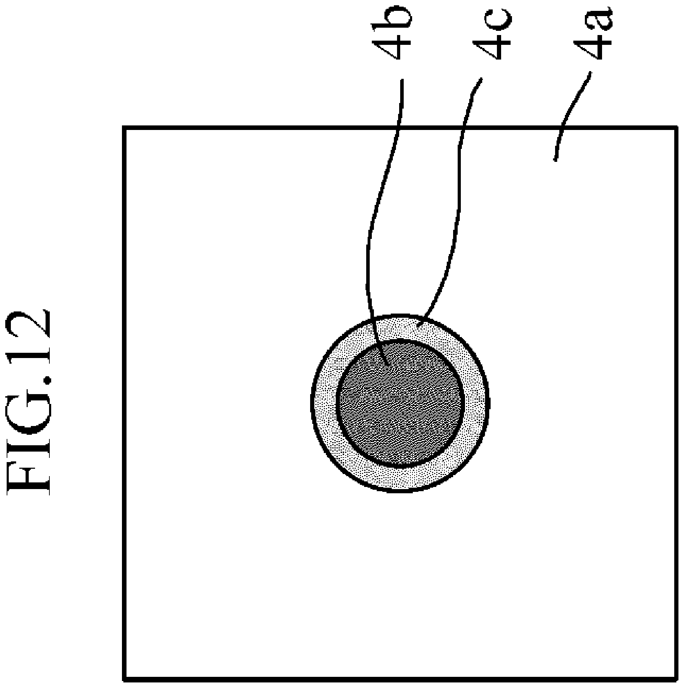

In addition, a mask configuration such as is shown in FIG. 12 (the symbols 4a in the drawing indicate the light-transmitting parts, 4b the light-shielding parts, and 4c the grayscale parts) is preferred as the photomask.

The present invention is not limited to the present example; the specific configuration of each constituent element can be designed as appropriate.

## Claims

1. A method for manufacturing a master mold for imprinting, the master mold having structures formed on a base material in a predetermined pattern such as a wiring pattern or a bump pattern, the method for manufacturing a master mold for imprinting **characterized by** comprising a coating step in which a resist having a predetermined film thickness is coated on the base material, an exposure step in which the resist coated on the base material is exposed through a mask, and a development step in which the exposed resist is developed, the exposure step involving setting the exposure amount to be equal to or less than twice Df (described below) and exposing predetermined portions of the resist so that the side surface shape of the structures constituted of the resist formed by development in the development step is a forward taper.
Df: the minimum exposure amount at which the resist coated on the base material undergoes solarization across the entire thickness of the resist

2. The method for manufacturing a master mold for imprinting according to claim 1, **characterized in that** in the exposure step, a binary mask constituted of light-transmitting parts and light-shielding parts is used as the mask, and the exposure amount is set to D0 (described below) to Df (described above).
D0: the exposure amount at which the resist coated on the base material begins to undergo solarization

3. The method for manufacturing a master mold for imprinting according to claim 1, **characterized in that** in the exposure step, a grayscale mask constituted of light-transmitting parts, light-shielding parts, and grayscale parts is used.

4. The method for manufacturing a master mold for imprinting according to claim 3, **characterized in that** the grayscale parts are provided along opening edges of the light-transmitting parts.

5. The method for manufacturing a master mold for imprinting according to any one of claims 1 to 4, **characterized in that** the exposure amount is determined on the basis of data on the relationship between the exposure amount for a predetermined thickness of the resist, which is ascertained in advance, and the taper angle of the forward taper.

6. The method for manufacturing a master mold for imprinting according to any one of claims 1 to 4, **characterized in that** a light-transmitting material is used as the base material, a negative resist is used as the resist, the method further comprises a mask formation step in which the mask is formed on the front surface of the base material, and the exposure step involves directing light onto the base material from the back-surface side thereof and exposing the resist through the mask formed on the front surface of the base material.

7. The method for manufacturing a master mold for imprinting according to claim 5, **characterized in that** a light-transmitting material is used as the base material, a negative resist is used as the resist, the method further comprises a mask formation step in which the mask is formed on the front surface of the base material, and the exposure step involves directing light onto the base material from the back-surface side thereof and exposing the resist through the mask formed on the front surface of the base material.
